# EUROPEAN PATENT APPLICATION

(11) **EP 4 773 773 A1**
(43) Date of publication of application: **08.07.2026**
(21) Application number: 23950197.6
(22) Date of filing: 31.08.2023
(51) Int. Cl.: H10K 59/131

(54) **DISPLAY SUBSTRATE AND DISPLAY APPARATUS**

(71) Applicant: BOE Technology Group Co., Ltd., Beijing 100015 (CN); Beijing BOE Technology Development Co., Ltd., Beijing 100176 (CN)
(72) Inventor: ZHANG, Xing, Beijing 100176 (CN); XU, Pan, Beijing 100176 (CN); HAN, Ying, Beijing 100176 (CN); LV, Guangshuang, Beijing 100176 (CN); ZHAO, Donghui, Beijing 100176 (CN); ZHOU, Dandan, Beijing 100176 (CN); ZHANG, Dacheng, Beijing 100176 (CN); CHEN, Yi, Beijing 100176 (CN)
(74) Representative: Potter Clarkson
(86) International application number: PCT/CN2023/116153
(87) International publication number: WO 2025/043612

(57) **Abstract**

A display substrate and a display device are provided. The display substrate includes: a base substrate; a plurality of pixel units, including a plurality of sub-pixels arranged in an array in a first direction and a second direction, wherein the plurality of sub-pixels include first and second sub-pixels in adjacent rows and the same column; a sensing transistor for driving a sub-pixel, including a third gate and a third active layer; and a scanning signal line including a main body portion extending in the first direction and a plurality of protruding portions extending in the second direction. The plurality of protruding portions include a first protruding portion and a second protruding portion, an orthographic projection of the first protruding portion on the base substrate and an orthographic projection of the second protruding portion on the base substrate at least partially overlap with a third active layer of a sensing transistor of the first sub-pixel and a third active layer of a sensing transistor of the second sub-pixel, respectively, and the overlapping parts are a third gate of the sensing transistor of the first sub-pixel and a third gate of the sensing transistor of the second sub-pixel, respectively. The third gate of the sensing transistor of the first sub-pixel and the third gate of the sensing transistor of the second sub-pixel are respectively on both sides of a main body portion of a same scanning signal line in the second direction.

## Description

### TECHNICAL FIELD

The present disclosure relates to a field of display technology, and in particular, to a display substrate and a display device.

### BACKGROUND

Organic Light Emitting Diode (OLED) devices have attracted much attention due to their advantages of self-illumination, rich color, fast response speed, wide viewing angle, light weight, thin thickness, low power consumption, and flexible display, which are now widely used in mobile phones, televisions, and wearable devices. With the continuous development of display technology, people's demand for the image quality of OLED display panels is also increasing. Pixels Per Inch (PPI) display panels have high image density and superior image quality. However, the higher the PPI of the display panel, the smaller the pixel size and the wiring space.

One of the important research topics for R&D personnel is how to reasonably arrange devices and signal lines in a limited space, while taking into account an aperture ratio of pixels, improving the space utilization of display products, increasing the aperture ratio, and increasing the lifespan of display panels.

It should be noted that the information disclosed in the background technology section above is only intended to enhance the understanding of the background of the present disclosure, and thus may include information that does not constitute a related art known to those skilled in the art.

### SUMMARY

In an aspect, a display substrate is provided, including: a base substrate; a plurality of pixel units on the base substrate, wherein at least one of the plurality of pixel units includes a plurality of sub-pixels, at least one of the plurality of sub-pixels includes a light-emitting element and a pixel driving circuit used to drive the light-emitting element, the plurality of sub-pixels of the plurality of pixel units are arranged in an array in a first direction and a second direction on the base substrate, and the first direction intersects with the second direction; a scanning signal line on the base substrate, wherein the scanning signal line includes a main body portion extending in the first direction and a plurality of protruding portions extending in the second direction, wherein the pixel driving circuit includes a sensing transistor, and the sensing transistor includes a third gate and a third active layer; wherein the plurality of sub-pixels of at least one pixel unit include a first sub-pixel and a second sub-pixel, the first sub-pixel is in an i^{th} row and a j^{th} column, the second sub-pixel is in an (i+1)^{th} row and the j^{th} column, and i and j are positive integers greater than or equal to 1; wherein the plurality of protruding portions include a first protruding portion and a second protruding portion, an orthographic projection of the first protruding portion on the base substrate at least partially overlaps with a third active layer of a sensing transistor of the first sub-pixel, a part of the first protruding portion overlapping with the third active layer of the sensing transistor of the first sub-pixel is a third gate of the sensing transistor of the first sub-pixel; an orthographic projection of the second protruding portion on the base substrate at least partially overlaps with a third active layer of a sensing transistor of the second sub-pixel, and a part of the second protruding portion overlapping with the third active layer of the sensing transistor of the second sub-pixel is a third gate of the sensing transistor of the second sub-pixel; and wherein the third gate of the sensing transistor of the first sub-pixel and the third gate of the sensing transistor of the second sub-pixel are respectively on both sides of a main body portion of the same scanning signal line in the second direction.

According to some exemplary embodiments, the plurality of sub-pixels of at least one pixel unit further include a third sub-pixel and a fourth sub-pixel, the third sub-pixel is in the i^{th} row and a (j+1)^{th} column, and the fourth sub-pixel is in the (i+1)^{th} row and the (j+1)^{th} column; wherein the plurality of protruding portions further include a third protruding portion and a fourth protruding portion, an orthographic projection of the third protruding portion on the base substrate at least partially overlaps with a third active layer of a sensing transistor of the third sub-pixel, a part of the third protruding portion overlapping with the third active layer of the sensing transistor of the third sub-pixel is a third gate of the sensing transistor of the third sub-pixel; an orthographic projection of the fourth protruding portion on the base substrate at least partially overlaps with a third active layer of a sensing transistor of the fourth sub-pixel, and a part of the fourth protruding portion overlapping with the third active layer of the sensing transistor of the fourth sub-pixel is a third gate of the sensing transistor of the fourth sub-pixel; and wherein the third gate of the sensing transistor of the third sub-pixel and the third gate of the sensing transistor of the fourth sub-pixel are respectively on both sides of the main body portion of the same scanning signal line in the second direction.

According to some exemplary embodiments, the display substrate further includes a sensing signal line extending in the second direction, and the sensing signal line is used to provide a sensing signal to the pixel driving circuit; and wherein the third gate of the sensing transistor of the first sub-pixel and the third gate of the sensing transistor of the third sub-pixel are respectively on both sides of the same sensing signal line in the first direction; and/or, the third gate of the sensing transistor of the second sub-pixel and the third gate of the sensing transistor of the fourth sub-pixel are respectively on both sides of the same sensing signal line in the first direction.

According to some exemplary embodiments, the third active layer of the sensing transistor further includes a channel region, a first electrode region, and a second electrode region; wherein an orthographic projection of the channel region of the third active layer on the base substrate at least partially overlaps with an orthographic projection of the third gate on the base substrate, and the first electrode region and the second electrode region are respectively on both sides of the channel region of the third active layer in the first direction; and wherein at least a part of the third active layer between a channel region of the sensing transistor of the first sub-pixel and a channel region of the sensing transistor of the third sub-pixel is used as both a first electrode region of the sensing transistor of the first sub-pixel and a second electrode region of the sensing transistor of the third sub-pixel; and/or, at least a part of the third active layer between a channel region of the sensing transistor of the second sub-pixel and a channel region of the sensing transistor of the fourth sub-pixel is used as both a first electrode region of the sensing transistor of the second sub-pixel and a second electrode region of the sensing transistor of the fourth sub-pixel.

According to some exemplary embodiments, the third gate of the sensing transistor of the first sub-pixel and the third gate of the sensing transistor of the third sub-pixel are symmetrical relative to a first centerline, and the first centerline is an imaginary straight line that passes through a center of a sensing line and extends in the second direction; and/or wherein the third gate of the sensing transistor of the second sub-pixel and the third gate of the sensing transistor of the fourth sub-pixel are symmetrical relative to the first centerline.

According to some exemplary embodiments, the third active layer of the sensing transistor of the first sub-pixel and the third active layer of the sensing transistor of the third sub-pixel are connected to each other and extend in the first direction.

According to some exemplary embodiments, the first protruding portion and the second protruding portion protrude in the second direction from the main body portion of the same scanning signal line towards opposite directions, and the first protruding portion and the second protruding portion are offset in the first direction by a first predetermined distance; and/or, wherein the third protruding portion and the fourth protruding portion protrude in the second direction from the main body portion of the same scanning signal line towards opposite directions, and the third protruding portion and the fourth protruding portion are offset in the first direction by a second predetermined distance.

According to some exemplary embodiments, the pixel driving circuit further includes a switching transistor, and the switching transistor includes a second gate and a second active layer; wherein the plurality of protruding portions include a fifth protruding portion and a sixth protruding portion, an orthographic projection of the fifth protruding portion on the base substrate at least partially overlaps with a second active layer of a switching transistor of the first sub-pixel, a part of the fifth protruding portion overlapping with the second active layer of the switching transistor of the first sub-pixel is a second gate of the switching transistor of the first sub-pixel; an orthographic projection of the sixth protruding portion on the base substrate at least partially overlaps with a second active layer of a switching transistor of the second sub-pixel, and a part of the sixth protruding portion overlapping with the second active layer of the switching transistor of the second sub-pixel is a second gate of the switching transistor of the second sub-pixel; and wherein the second gate of the switching transistor of the first sub-pixel and the second gate of the switching transistor of the second sub-pixel are respectively on both sides of the main body portion of the same scanning signal line in the second direction.

According to some exemplary embodiments, the fifth protruding portion and the sixth protruding portion protrude in the second direction from the main body portion of the same scanning signal line towards opposite directions, and the fifth protruding portion and the sixth protruding portion are offset in the first direction by a third predetermined distance.

According to some exemplary embodiments, any two of the first predetermined distance, the second predetermined distance, and the third predetermined distance are substantially equal.

According to some exemplary embodiments, a sensing signal line includes a line main body portion and a first line protruding portion, and the first line protruding portion protrudes from the line main body portion towards the first sub-pixel; wherein the display substrate further includes a first conductive connection portion, the first conductive connection portion, the first protruding portion, and the third protruding portion are in the same layer, and the first conductive connection portion is between the first protruding portion and the third protruding portion in the first direction; and wherein an orthographic projection of the first line protruding portion on the base substrate at least partially overlaps with an orthographic projection of the first conductive connection portion on the base substrate, and the first line protruding portion is electrically connected to the first conductive connection portion through a first via hole.

According to some exemplary embodiments, an orthographic projection of one of the first conductive connection portion and the first via hole on the base substrate at least partially overlaps with an orthographic projection of a part of the third active layer used as both a first electrode region of the sensing transistor of the first sub-pixel and a second electrode region of the sensing transistor of the third sub-pixel on the base substrate.

According to some exemplary embodiments, the display substrate further includes a second conductive connection portion, the second conductive connection portion, the first protruding portion, and a fifth protruding portion are in the same layer, and the second conductive connection portion is between the first protruding portion and the fifth protruding portion in the first direction; and wherein the display substrate further includes a light shielding portion on the base substrate, orthographic projections of any two of the light shielding portion, a second electrode region of the sensing transistor of the first sub-pixel, and the second conductive connection portion on the base substrate at least partially overlap, and the second electrode region of the sensing transistor of the first sub-pixel is electrically connected to the light shielding portion through the second conductive connection portion and a second via hole.

According to some exemplary embodiments, an orthographic projection of a second active layer on the base substrate at least partially overlaps with an orthographic projection of the light shielding portion on the base substrate; and wherein the pixel driving circuit further includes a storage capacitor, the storage capacitor includes a first electrode plate and a second electrode plate, at least a part of the second active layer is used as the first electrode plate, and at least a part of the light shielding portion is used as the second electrode plate.

According to some exemplary embodiments, the sensing signal line further includes a first widening portion, a width of the first widening portion in the first direction is greater than a width of the line main body portion in the first direction, and an orthographic projection of the first widening portion on the base substrate is between an orthographic projection of a first electrode plate of a storage capacitor of the first sub-pixel on the base substrate and an orthographic projection of a first electrode plate of a storage capacitor of the third sub-pixel on the base substrate in the first direction; and/or, wherein the sensing signal line further includes a second widening portion, a width of the second widening portion in the first direction is greater than the width of the line main body portion in the first direction, and an orthographic projection of the second widening portion on the base substrate is between an orthographic projection of a first electrode plate of a storage capacitor of the second sub-pixel on the base substrate and an orthographic projection of a first electrode plate of a storage capacitor of the fourth sub-pixel on the base substrate in the first direction.

According to some exemplary embodiments, the orthographic projection of the first widening portion on the base substrate and the orthographic projection of the first electrode plate of the storage capacitor of the first sub-pixel on the base substrate are spaced by a first spacing distance in the first direction; the orthographic projection of the first widening portion on the base substrate and the orthographic projection of the first electrode plate of the storage capacitor of the third sub-pixel on the base substrate are spaced by a second spacing distance in the first direction; and the first spacing distance is substantially equal to the second spacing distance; and/or, wherein the orthographic projection of the second widening portion on the base substrate and the orthographic projection of the first electrode plate of the storage capacitor of the second sub-pixel on the base substrate are spaced by a third spacing distance in the first direction; the orthographic projection of the second widening portion on the base substrate and the orthographic projection of the first electrode plate of the storage capacitor of the fourth sub-pixel on the base substrate are spaced by a fourth spacing distance in the first direction; and the third spacing distance is substantially equal to the fourth spacing distance.

According to some exemplary embodiments, the display substrate further includes a first conductive connection portion, and the first conductive connection portion, the first protruding portion, and the second protruding portion are in the same layer; and wherein the orthographic projection of the first widening portion on the base substrate at least partially overlaps with an orthographic projection of the first conductive connection portion on the base substrate, and the first widening portion is electrically connected to the first conductive connection portion through the first via hole.

According to some exemplary embodiments, the third active layer further includes an active extension portion, and the active extension portion extends from the part of the third active layer used as both the first electrode region of the sensing transistor of the first sub-pixel and the second electrode region of the sensing transistor of the third sub-pixel in a direction parallel to an extension direction of the sensing signal line; wherein an orthographic projection of the active extension portion on the base substrate at least partially overlaps with an orthographic projection of the sensing signal line on the base substrate; and wherein the active extension portion is electrically connected to the first conductive connection portion.

According to some exemplary embodiments, the second active layer includes a first part extending in the first direction, a second part extending in the second direction, and a third part used as the first electrode plate, a part of the first part overlapping with the fifth protruding portion is a channel region of a switching transistor, and the second part is connected with the first part and the third part; and wherein a width of the second part in the first direction is greater than a width of the first part in the second direction.

According to some exemplary embodiments, the pixel driving circuit further includes a driving transistor, and the driving transistor includes a first active layer; wherein the display substrate further includes a fifth conductive connection portion and a first power signal line used to transmit a first power signal, the fifth conductive connection portion and the scanning signal line are in the same layer, and the first power signal line and the sensing signal line are in the same layer; wherein an end of the fifth conductive connection portion is electrically connected to the first active layer through a fifth via hole, and the other end of the fifth conductive connection portion is electrically connected to the first power signal line through a sixth via hole; and wherein the fifth conductive connection portion is shared by two sub-pixels in adjacent rows of pixel units and in the same column.

According to some exemplary embodiments, the display substrate includes: a semiconductor layer on the base substrate; a first conductive layer on a side of the semiconductor layer away from the base substrate; a second conductive layer on a side of the first conductive layer away from the base substrate; and a light shielding layer on a side of the semiconductor layer facing the base substrate, wherein the light shielding portion is in the light shielding layer, the first active layer, the second active layer, and the third active layer are in the semiconductor layer, the scanning signal line, the first conductive connection portion, and the second conductive connection portion are in the first conductive layer, and the sensing signal line and the first power line are in the second conductive layer.

According to some exemplary embodiments, the display substrate further includes: a pixel defining layer on a side of the second conductive layer away from the base substrate, wherein the pixel defining layer is used to define a plurality of pixel openings; and a reflective electrode layer on a side of the pixel defining layer away from the base substrate; and wherein the pixel defining layer is further used to define a plurality of slots, the plurality of slots are respectively between any two adjacent pixel openings, and at least a part of the reflective electrode layer is in the plurality of slots.

According to some exemplary embodiments, the display substrate further includes a first conductive portion on a side of the light shielding layer facing the base substrate; and a second conductive portion in the semiconductor layer; wherein an orthographic projection of the first conductive portion on the base substrate at least partially overlaps with an orthographic projection of the pixel opening on the base substrate, and an orthographic projection of the second conductive portion on the base substrate at least partially overlaps with the orthographic projection of the pixel opening on the base substrate; and wherein the first electrode plate further includes the second conductive portion, the second electrode plate further includes the first conductive portion, the first conductive portion is electrically connected to the light shielding portion, and the first conductive portion includes a transparent conductive material.

According to some exemplary embodiments, the display substrate further includes a plurality of data lines in the second conductive layer, the plurality of data lines include a first data line, a second data line, a third data line, and a fourth data line, the first data line is electrically connected to a first electrode of the switching transistor of the first sub-pixel, the second data line is electrically connected to a first electrode of the switching transistor of the second sub-pixel, the third data line is electrically connected to a first electrode of a switching transistor of the third sub-pixel, and the fourth data line is electrically connected to a first electrode of a switching transistor of the fourth sub-pixel; and wherein the first and second data lines are on a side of the pixel driving circuit of the pixel unit in the first direction, the third and fourth data lines are on the other side of the pixel driving circuit of the pixel unit in the first direction, the first and second data lines are spaced in the first direction, the first data line is on a side of the second data line away from the pixel driving circuit of the pixel unit, and the fourth data line is on a side of the third data line away from the pixel driving circuit of the pixel unit.

In another aspect, a display device is provided, including the display substrate as described in any one of the preceding items.

### BRIEF DESCRIPTION OF THE DRAWINGS

The above and other objects, features, and advantages of the present disclosure will become more clear through following description on embodiments of the present disclosure with reference to accompanying drawings, in which:
FIG. 1 is a planar schematic diagram of a display substrate according to an embodiment of the present disclosure;
FIG. 2A is an equivalent circuit diagram of pixel driving circuits for a plurality of sub-pixels of the display substrate in FIG. 1, and FIG. 2B is an equivalent circuit diagram of a pixel circuit for a single sub-pixel of the display substrate in FIG. 1;
FIG. 3 is a local plan view of a display substrate according to some embodiments of the present disclosure, which schematically shows a plan view of a pixel driving circuit and a first electrode of a light-emitting element included in the display substrate;

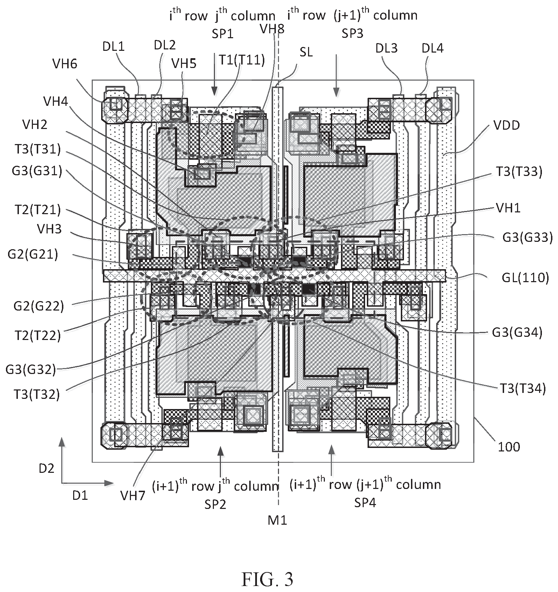

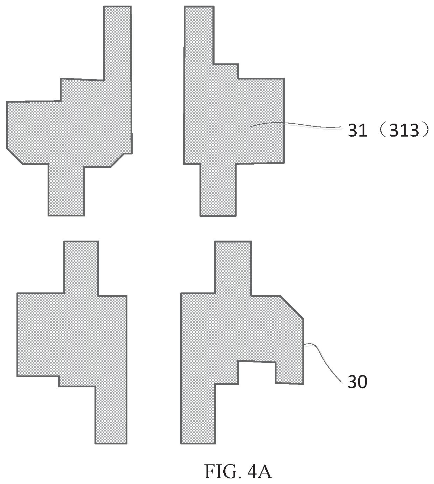

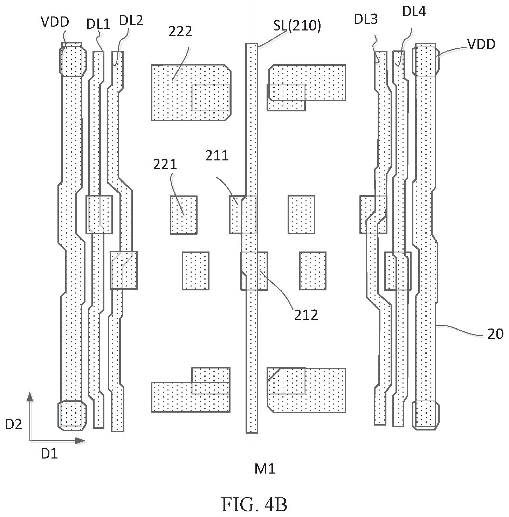

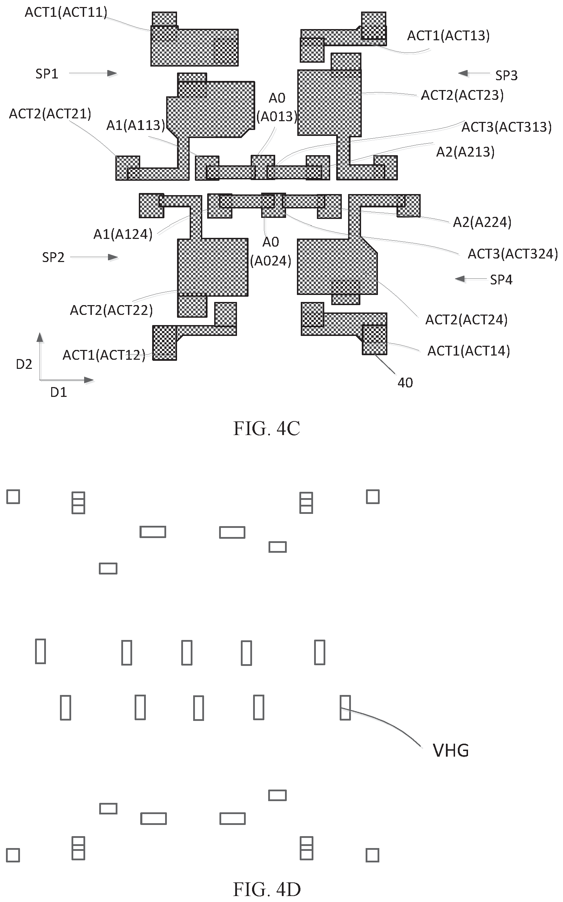

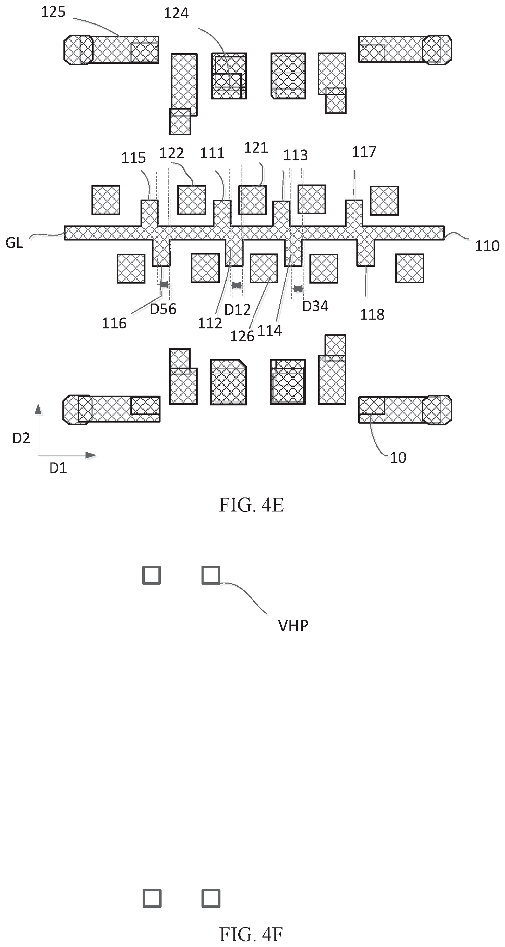

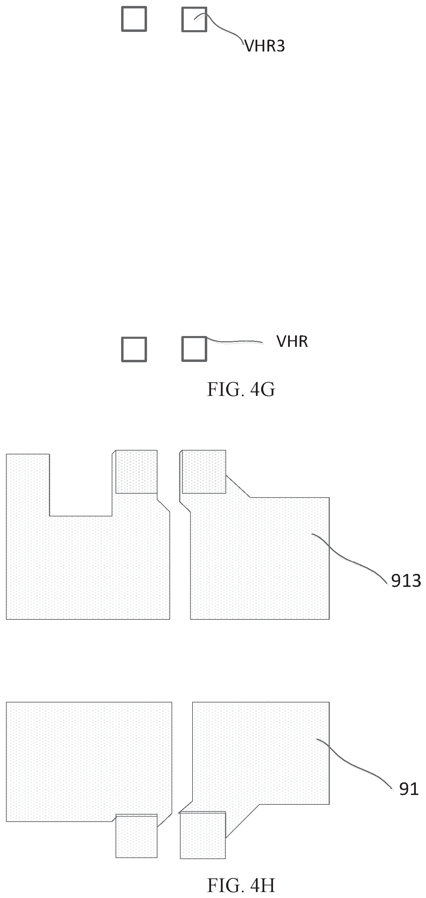

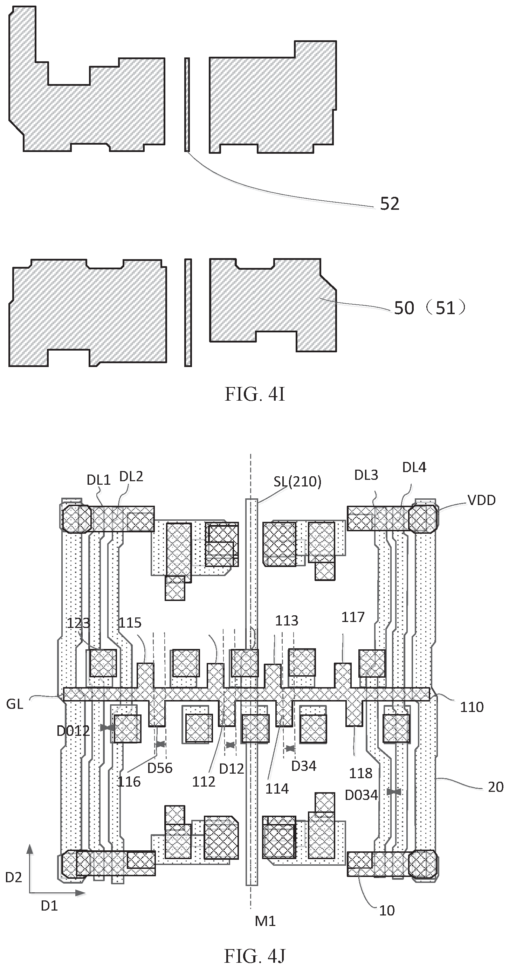

FIGS. 4A to 4I are plane views of a plurality of film layers shown in FIG. 3 respectively, wherein FIG. 4A shows a light shielding layer 30 including a plurality of light shielding portions 31; FIG. 4B shows a second conductive layer 20; FIG. 4C shows an active layer 40; FIG. 4D shows a plurality of GI via holes; FIG. 4E shows a first conductive layer 10; FIG. 4F shows a plurality of passivation layer PVX via holes; FIG. 4G shows first electrode via holes of a plurality of light-emitting elements; FIG. 4H shows a first electrode of a light-emitting element; FIG. 4I shows a pixel defining layer; FIG. 4J shows a schematic diagram of a combined film layer of a second conductive layer 20 and a first conductive layer 10;
FIG. 5 is a local enlarged view of a region close to a dashed rectangular region in FIG. 3;
FIG. 6A is a cross-sectional view taken along a dashed line 1 in FIG. 5, and FIG. 6B is a cross-sectional view taken along a dashed line 2 in FIG. 5, wherein an orthographic projection of the dashed line 1 and an orthographic projection of the dashed line 2 on a base substrate partially overlap with a second via hole VH2;
FIG. 7 is a planar schematic diagram of a stack of a local light shielding layer 30 and an active layer 40 according to some exemplary embodiments of the present disclosure;
FIG. 8 is a local plan view of a display substrate according to other embodiments of the present disclosure, which shows a widening portion of a sensing signal line;
FIG. 9 is a local enlarged view of a region close to a dashed box above in FIG. 8;
FIG. 10 is a local plan view of a display substrate according to other embodiments of the present disclosure, which shows an active extension portion of a third active layer;
FIG. 11 is a local enlarged view of a region close to a scanning signal line in the middle of FIG. 10;
FIG. 12 is a local plan view of a display substrate according to other embodiments of the present disclosure; and
FIG. 13 is a local cross-section view of a display substrate according to other embodiments of the present disclosure.

It should be noted that for clarity, the dimensions of layers, structures, or regions may be enlarged or reduced in the drawings used to describe embodiments of the present disclosure, that is, these drawings are not drawn to actual proportions.

### DETAILED DESCRIPTION OF EMBODIMENTS

In order to make the purposes, technical solutions, and advantages of embodiments of the present disclosure clearer, the following will provide a clear and complete description of the technical solution of embodiments of the present disclosure in conjunction with accompanying drawings of embodiments of the present disclosure. Clearly, the described embodiments are a part of embodiments of the present disclosure, rather than the entire embodiments. Based on the described embodiments of the present disclosure, all other embodiments obtained by those ordinary skilled in the art without the need for creative labor fall within the scope of protection of the present disclosure.

It should be noted that in the accompanying drawings, for clarity and/or descriptive purposes, the dimensions and relative dimensions of the elements may be enlarged. In this way, the dimensions and relative dimensions of each element need not be limited to the dimensions and relative dimensions shown in the figures. In the specification and drawings, the same or similar reference numbers indicate the same or similar components.

Unless otherwise defined, technical or scientific terms used in the present disclosure shall have the usual meaning understood by those ordinary skilled in the art. The terms "first", "second", and similar terms used in the present disclosure do not indicate any order, quantity, or importance, but are only used to distinguish different components. Words such as "including" or "containing" refer to elements or objects that appear before the word include elements or objects and their equivalents listed after the word, without excluding other elements or objects.

In the present disclosure, unless otherwise specified, directional terms such as "up", "down", "left", "right", "inside", "outside" are used to represent orientation or positional relationships based on the drawings, only for the purpose of describing the present disclosure, and not to indicate or imply that the device, element or component referred to must have a specific orientation, be constructed or operated in a specific orientation. It should be understood that when the absolute position of the described object changes, the relative positional relationship it represents may also change accordingly. Therefore, these directional terms cannot be understood as limitations on the present disclosure.

It should be noted that in the present disclosure, the term "same layer" refers to a layer structure formed by using the same film-forming process to form a film layer with a specific pattern, followed by patterning the film layer through a single patterning process using the same mask. Depending on the specific shape, the single patterning process may include multiple exposure, development, or etching processes, and the specific shape in the formed layer structure may be continuous or discontinuous. That is, a plurality of elements, components, structures, and/or parts located in the "same layer" are composed of the same material and formed through the same patterning process. Typically, the plurality of elements, components, structures, and/or parts located in the "same layer" have substantially the same thickness.

Those skilled in the art should understand that in the present disclosure, unless otherwise specified, the term "height" or "thickness" refers to the dimensions along the surface of each film layer provided perpendicular to the display substrate, that is, the dimensions in the direction of light output of the display substrate, or the dimensions in the normal direction of the display device.

In the present disclosure, directional expressions such as "first direction" and "second direction" are used to describe different directions along pixel units, such as the vertical and horizontal directions of pixel units, or the row and column directions of sub-pixel arrangements. It should be understood that such representation is only an illustrative description and not a limitation on the present disclosure.

In the present disclosure, the term "transistor" may refer to a triode, a thin film transistor, a field effect transistor, or other devices with same characteristics. In embodiments of the present disclosure, in order to distinguish the two electrodes of the transistor except for the control electrode, one electrode is referred to as a first electrode and the other electrode is referred to as a second electrode. In practical operation, when the transistor is the thin film transistor or the field effect transistor, the first electrode may be a drain, and the second electrode may be a source; alternatively, the first electrode may be the source, and the second electrode may be the drain.

Some exemplary embodiments of the present disclosure provide a display substrate, including: a base substrate; a plurality of pixel units on the base substrate, where at least one of the plurality of pixel units includes a plurality of sub-pixels, at least one of the plurality of sub-pixels includes a light-emitting element and a pixel driving circuit used to drive the light-emitting element, the plurality of sub-pixels of the plurality of pixel units are arranged in an array in a first direction and a second direction on the base substrate, and the first direction intersects with the second direction; and a scanning signal line on the base substrate, where the scanning signal line includes a main body portion extending in the first direction and a plurality of protruding portions extending in the second direction. The pixel driving circuit includes a sensing transistor, and the sensing transistor includes a third gate and a third active layer. The plurality of sub-pixels of at least one pixel unit include a first sub-pixel and a second sub-pixel, the first sub-pixel is in an i^{th} row and a j^{th} column, the second sub-pixel is in an (i+1)^{th} row and the j^{th} column, and i and j are positive integers greater than or equal to 1. The plurality of protruding portions include a first protruding portion and a second protruding portion, an orthographic projection of the first protruding portion on the base substrate at least partially overlaps with a third active layer of a sensing transistor of the first sub-pixel, a part of the first protruding portion overlapping with the third active layer of the sensing transistor of the first sub-pixel is a third gate of the sensing transistor of the first sub-pixel. An orthographic projection of the second protruding portion on the base substrate at least partially overlaps with a third active layer of a sensing transistor of the second sub-pixel, and a part of the second protruding portion overlapping with the third active layer of the sensing transistor of the second sub-pixel is a third gate of the sensing transistor of the second sub-pixel. The third gate of the sensing transistor of the first sub-pixel and the third gate of the sensing transistor of the second sub-pixel are respectively on both sides of a main body portion of a same scanning signal line in the second direction. In this way, the sensing transistors of sub-pixels may be evenly distributed on upper and lower sides of the gate line, greatly improving space utilization, increasing the aperture ratio of the display panel, and increasing the lifespan of the display panel.

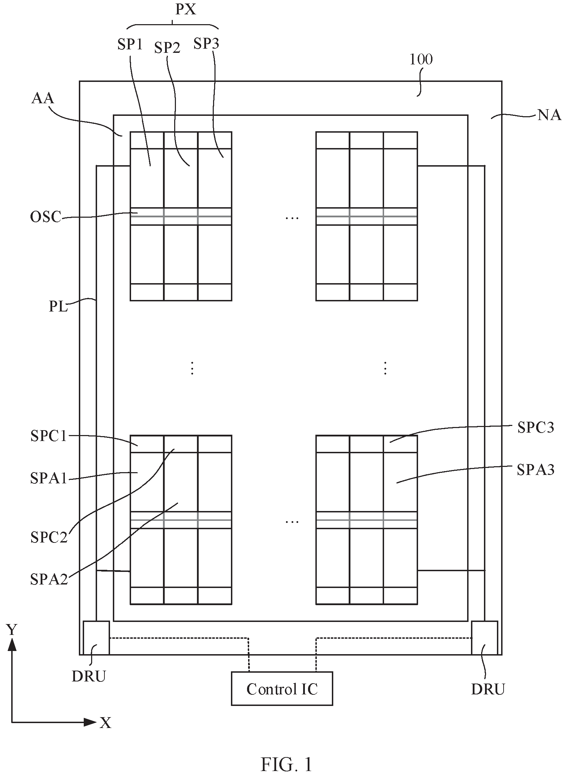

FIG. 1 is a planar schematic diagram of a display substrate according to an embodiment of the present disclosure.

Referring to FIG. 1, a display substrate according to an embodiment of the present disclosure may include a base substrate 100, pixel units PX provided on the base substrate 100, driving units DRU provided on the base substrate 100, and wirings PL electrically connecting the pixel units PX to the driving units DRU. The driving unit DRU is used to drive the pixel unit PX.

The display substrate may include a display region AA and a non-display region NA. The display region AA may be a region provided with pixel units PX for displaying images. Each pixel unit PX may be described later. The non-display region NA is a region where pixel units PX are not provided, that is, a region not for displaying images. The driving unit DRU used to drive the pixel unit PX and some wirings PL connecting the pixel units PX to the driving units DRU may be provided in the non-display region NA. The non-display region NA corresponds to a border in the resultant display device. A width of the border may be determined based on a width of the non-display region NA.

The display region AA may have various shapes. For example, the display region AA may be provided in various shapes such as closed polygons (such as rectangles) with straight edges, circles and ellipses with curved edges, and semicircles and semi-ellipses with straight and curved edges. In embodiments of the present disclosure, the display region AA is provided as a region in a quadrilateral shape with straight edges. It should be understood that this is only an exemplary embodiment of the present disclosure and not a limitation on the present disclosure.

The non-display region NA may be provided on at least one side of the display region AA. In embodiments of the present disclosure, the non-display region NA may surround a periphery of the display region AA. In embodiments of the present disclosure, the non-display region NA may include a horizontal part extending in a first direction X and a vertical part extending in a second direction Y.

The pixel units PX are provided in the display region AA. The pixel unit PX is the smallest unit used to display images, and a plurality of pixel units may be provided. For example, the pixel unit PX may include a light-emitting device that emits white light and/or colored light.

The plurality of pixel units PX may be provided and arranged in a matrix form along rows extending in the first direction X and columns extending in the first direction Y. However, in embodiments of the present disclosure, the arrangement form of the pixel units PX are not specifically limited, and the pixel units PX may be arranged in various forms. For example, the pixel units PX may be arranged so that a direction tilted relative to the first direction X and the first direction Y becomes a column direction, and a direction intersecting with the column direction becomes a row direction.

One pixel unit PX may include a plurality of sub-pixels. For example, one pixel unit PX may include three sub-pixels, namely a first sub-pixel SP1, a second sub-pixel SP2, and a third sub-pixel SP3. For another example, one pixel unit PX may include four sub-pixels, namely a first sub-pixel SP1, a second sub-pixel SP2, a third sub-pixel SP3, and a fourth sub-pixel. For example, the first sub-pixel SP1 may be a red sub-pixel, the second sub-pixel SP2 may be a green sub-pixel, the third sub-pixel SP3 may be a blue sub-pixel, and the fourth sub-pixel may be a white sub-pixel.

Each sub-pixel may include a light-emitting element and a pixel driving circuit for driving the light-emitting element. For example, the first sub-pixel SP1 may include a first light-emitting element located in a first light-emitting region SPA1 and a first pixel driving circuit SPC1 for driving the first light-emitting element, where the first light-emitting element may emit red light. The second sub-pixel SP2 may include a second light-emitting element located in a second light-emitting region SPA2 and a second pixel driving circuit SPC2 for driving the second light-emitting element, where the second light-emitting element may emit green light. The third sub-pixel SP3 may include a third light-emitting element located in a third light-emitting region SPA3 and a third pixel driving circuit SPC3 for driving the third light-emitting element, where the third light-emitting element may emit blue light.

A light-emitting region of the sub-pixel may be a region where the light-emitting element of the sub-pixel is located. For example, in an OLED display panel, the light-emitting element of the sub-pixel may include a stack of a first electrode (such as an anode), a light-emitting material layer, and a second electrode (such as a cathode). In this way, the light-emitting region of the sub-pixel may be a region corresponding to the light-emitting material layer sandwiched by the anode and the cathode.

The sub-pixel further includes a non-light-emitting region. For example, the pixel driving circuit of the sub-pixel is located in the non-light-emitting region of the sub-pixel. A ratio of an area of the light-emitting region of each sub-pixel to the overall area of the sub-pixel (the sum of the area of the light-emitting region and an area of the non-light-emitting region) determines an aperture ratio of the sub-pixel.

The light-emitting device (such as the light-emitting layer, abbreviated as an EL layer) of OLED may not have good consistency during fabrication. For example, when using the evaporation process to fabricate the EL layer, the limitations of the evaporation process may result in inconsistent EL layers of sub-pixels fabricated, leading to uneven light-emitting brightness or chromaticity between different sub-pixels. Moreover, as the usage time increases, the EL layers may experience varying degrees of aging, which may also lead to inconsistent EL layers of sub-pixels, resulting in uneven light-emitting brightness or chromaticity between different sub-pixels. In an embodiment of the present disclosure, the display substrate may further include a photosensitive circuit OSC, which may sense the actual light emitted by the pixel unit. In this way, in an embodiment of the present disclosure, the display substrate may perform optical compensation on the sub-pixels within each pixel unit based on the actual light emitted by the pixel unit sensed by the photosensitive circuit OSC, so as to improve the uniformity of light emitting of the display substrate.

For example, in some exemplary embodiments of the present disclosure, each pixel unit PX is provided with a photosensitive circuit OSC. Each photosensitive circuit OSC senses the actual light emitted by the pixel unit PX.

For example, in an embodiment of the present disclosure, at least two pixel units PX may share one photosensitive circuit OSC. Referring to FIG. 1, in the same column of pixel units, two pixel units PX located in adjacent two rows may share one photosensitive circuit OSC. In this way, there is no need to provide one photosensitive circuit for each pixel unit PX, which may reduce the number of photosensitive circuits and improve the aperture ratio. When the display substrate is in a display state, the photosensitive circuit OSC may sense the actual light emitted by the two pixel units adjacent to the photosensitive circuit OSC. For example, the photosensitive circuit OSC may at least include a photoelectric conversion element. In this way, the photosensitive circuit OSC may be used to: sense the actual light emitted by the two pixel units adjacent to the photosensitive circuit OSC; and transmit a sensing electrical signal according to the sensed light.

For another example, referring to FIG. 1, the photosensitive circuit OSC may transmit the sensing electrical signal to an external circuit, such as a control IC of the display device. The control IC may control a control signal transmitted to the pixel unit PX according to the sensing electrical signal, for example, may control a data signal transmitted to the pixel driving circuit of each sub-pixel. Under the control of the data signal, each sub-pixel emits light accordingly.

In the embodiment shown in FIG. 1, the sub-pixels SP1, SP2, and SP3 are provided side by side. Each of the sub-pixels SP1, SP2, and SP3 has a data line DL.

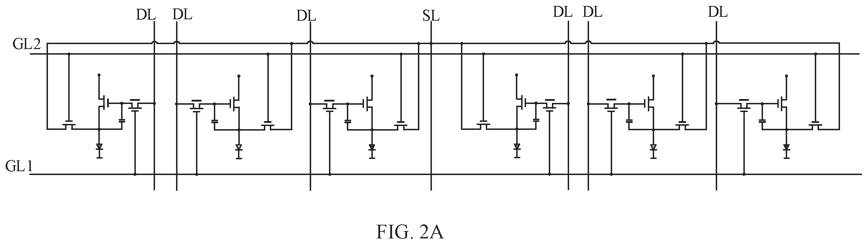

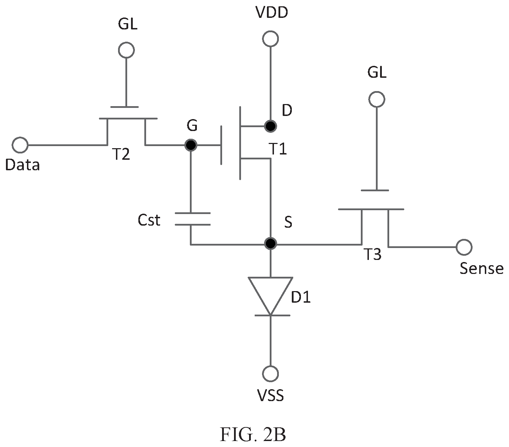

FIG. 2A is an equivalent circuit diagram of pixel driving circuits for a plurality of sub-pixels of the display substrate in FIG. 1, and FIG. 2B is an equivalent circuit diagram of a pixel circuit for a single sub-pixel of the display substrate in FIG. 1. The pixel driving circuit shown in FIG. 2B may be any of the pixel driving circuit SPC1, SPC2, or SPC3 described above. Referring to FIGS. 2A and 2B, the pixel driving circuit may include a plurality of elements such as a driving transistor T1, a switching transistor T2, a sensing transistor T3, and a storage capacitor Cst. The pixel driving circuit may be referred to as a 3T1C structure.

Is should be noted that the 3T1C structure is used as an example here to explain the pixel driving circuit included in the display substrate according to embodiments of the present disclosure. However, the pixel driving circuit included in the display substrate of embodiments of the present disclosure is not limited to the 3T1C structure.

Referring to FIG. 2B, a gate of the switching transistor T2 is connected to a scanning signal line GL. A first electrode of the switching transistor T2 is connected to a data line DL. A second electrode of the switching transistor T2 is connected to a gate of the driving transistor T1. For example, both the second electrode of the switching transistor T2 and the gate of the driving transistor T1 may be electrically connected to a node G. The switching transistor T2 is used to control the voltage signal from the data line DL to be written into the pixel driving circuit.

It should be noted that each transistor may include an active layer, a gate, a first electrode (such as a source), and a second electrode (such as a drain). For example, the driving transistor T1 includes a first gate G1 and a first active layer ACT1. The switching transistor T2 includes a second gate G2 and a second active layer ACT2. The sensing transistor T3 includes a third gate G3 and a third active layer ACT3. In embodiments of the present disclosure, the active layers of the transistors may be located in the semiconductor layer, and the gates may be located in different conductive layers.

It should be noted that in the present disclosure, the first electrode of the transistor may refer to one of the source and the drain of the transistor, and the second electrode of the transistor may refer to the other of the source and the drain of the transistor.

The gate of the driving transistor T1 is electrically connected to the node G. The first electrode of the driving transistor T1 is connected to a first power signal (such as a high voltage level signal VDD). The second electrode of the driving transistor T1 may be connected to an anode of the light-emitting element D1, so as to generate a driving current according to the voltage signal to drive the light-emitting element D1 to emit light. For example, the light-emitting element D1 may be an organic light-emitting diode (OLED).

Two terminals of the storage capacitor Cst are respectively connected to the gate and the source of the driving transistor T1 to store the voltage signal input from the data line. For example, one terminal of the storage capacitor Cst is electrically connected to the node G, and the other terminal of the storage capacitor Cst is electrically connected to the node S. That is, one terminal of the storage capacitor Cst, the second electrode of the switching transistor T2, and the gate of the driving transistor T1 are electrically connected to the node G, while the other terminal of the storage capacitor Cst, the second electrode of the driving transistor T1, and the anode of the light-emitting element D1 are electrically connected to the node S.

A gate of the sensing transistor T3 is connected to the scanning signal line GL. A first electrode of the sensing transistor T3 is connected to a sensing signal line SL. A second electrode of the sensing transistor T3 is electrically connected to the node S.

The anode of the light-emitting element D1 is electrically connected to the node S. The cathode of the light-emitting element D1 is electrically connected to a low voltage level signal VSS. Both the level signals VDD and VSS are DC voltage signals used to provide desired voltages for driving the light-emitting element D1 to emit light.

FIG. 3 is a local plan view of a display substrate according to some embodiments of the present disclosure, which schematically shows a plan view of a pixel driving circuit and a first electrode of a light-emitting element included in the display substrate. FIGS. 4A to 4I are plane views of a plurality of film layers shown in FIG. 3 respectively, where FIG. 4A shows a light shielding layer 30 including a plurality of light shielding portions 31; FIG. 4B shows a second conductive layer 20; FIG. 4C shows an active layer 40; FIG. 4D shows a plurality of GI via holes VHG; FIG. 4E shows a first conductive layer 10; FIG. 4F shows a plurality of passivation layer PVX via holes VHP; FIG. 4G shows first electrode via holes VHR of a plurality of light-emitting elements; FIG. 4H shows a first electrode of a light-emitting element; FIG. 4I shows a pixel defining layer; FIG. 4J shows a schematic diagram of a combined film layer of a second conductive layer 20 and a first conductive layer 10.

Referring to FIG. 1 and FIG. 3, the display substrate includes: a base substrate 100; a plurality of pixel units on the base substrate 100, where at least one of the plurality of pixel units includes a plurality of sub-pixels, the sub-pixel includes a light-emitting element and a pixel driving circuit used to drive the light-emitting element. For example, the driving circuit may include a driving transistor T1, a switching T2, and a sensing transistor T3. The plurality of sub-pixels of the plurality of pixel units are arranged in an array in a first direction D1 and a second direction D2 on the base substrate 100, and the first direction D1 intersects with the second direction D2. Referring to FIGS. 3, 4C, and 4E, the display substrate further includes a scanning signal line GL on the base substrate 100, where the scanning signal line includes a main body portion 110 extending in the first direction D1 and a plurality of protruding portions extending in the second direction D2. The pixel driving circuit includes a sensing transistor T3, and the sensing transistor T3 includes a third gate G3 and a third active layer ACT3. The plurality of sub-pixels of at least one pixel unit include a first sub-pixel SP1 and a second sub-pixel SP2. The first sub-pixel SP1 is in an i^{th} row and a j^{th} column, the second sub-pixel SP2 is in an (i+1)^{th} row and the j^{th} column, and i and j are positive integers greater than or equal to 1 .The plurality of protruding portions include a first protruding portion 111 and a second protruding portion 112, an orthographic projection of the first protruding portion 111 on the base substrate 100 at least partially overlaps with a third active layer ACT313 of a sensing transistor T31 of the first sub-pixel SP1, a part of the first protruding portion 111 overlapping with the third active layer ACT313 of the sensing transistor T31 of the first sub-pixel SP1 is a third gate G31 of the sensing transistor T31 of the first sub-pixel SP1. An orthographic projection of the second protruding portion 112 on the base substrate 100 at least partially overlaps with a third active layer ACT324 of a sensing transistor T32 of the second sub-pixel SP2, and a part of the second protruding portion 112 overlapping with the third active layer ACT324 of the sensing transistor T32 of the second sub-pixel SP2 is a third gate G32 of the sensing transistor T32 of the second sub-pixel SP2. The third gate G31 of the sensing transistor T31 of the first sub-pixel SP1 and the third gate G32 of the sensing transistor T32 of the second sub-pixel SP2 are respectively on both sides of a main body portion 110 of the same scanning signal line GL in the second direction.

In some exemplary embodiments of the present disclosure, referring to FIGS. 3, 4C, and 4E, the plurality of sub-pixels of at least one pixel unit also include a third sub-pixel SP3 and a fourth sub-pixel SP4, the third sub-pixel SP3 is in the i^{th} row and a (j+1)^{th} column, and the fourth sub-pixel SP4 is in the (i+1)^{th} row and the (j+1)^{th} column. The plurality of protruding portions also include a third protruding portion 113 and a fourth protruding portion 114, an orthographic projection of the third protruding portion 113 on the base substrate 100 at least partially overlaps with a third active layer ACT313 of a sensing transistor T33 of the third sub-pixel SP3, a part of the third protruding portion 113 overlapping with the third active layer ACT313 of the sensing transistor T33 of the third sub-pixel SP3 is a third gate G33 of the sensing transistor T33 of the third sub-pixel SP3. An orthographic projection of the fourth protruding portion 114 on the base substrate 100 at least partially overlaps with a third active layer ACT324 of a sensing transistor T34 of the fourth sub-pixel SP4, and a part of the fourth protruding portion 114 overlapping with the third active layer ACT324 of the sensing transistor T34 of the fourth sub-pixel SP4 is a third gate G34 of the sensing transistor T34 of the fourth sub-pixel SP4. The third gate G33 of the sensing transistor T33 of the third sub-pixel SP3 and the third gate G34 of the sensing transistor T34 of the fourth sub-pixel SP4 are respectively on both sides of the main body portion 110 of the same scanning signal line in the second direction.

By evenly distributing the sensing transistors of sub-pixels on upper and lower sides of the scanning signal line, the space utilization and the aperture ratio may be improved, which is conducive to achieving display panel design with high PPI.

In some exemplary embodiments of the present disclosure, referring to FIG. 3, the display substrate further includes a sensing signal line SL extending in the second direction D2, and the sensing signal line SL is used to provide a sensing signal to the pixel driving circuit. The third gate G31 of the sensing transistor T31 of the first sub-pixel SP1 and the third gate G33 of the sensing transistor T33 of the third sub-pixel SP3 are respectively on both sides of the same sensing signal line SL in the first direction D1; and/or, the third gate G32 of the sensing transistor T32 of the second sub-pixel SP2 and the third gate G34 of the sensing transistor T34 of the fourth sub-pixel SP4 are respectively on both sides of the same sensing signal line SL in the first direction D1.

In some exemplary embodiments of the present disclosure, referring to FIGS. 3 and 4C, the third active layer ACT3 of the sensing transistor T3 also includes a channel region A0, a first electrode region A1, and a second electrode region A2. An orthographic projection of the channel region A0 of the third active layer ACT3 on the base substrate 100 at least partially overlaps with an orthographic projection of the third gate G3 on the base substrate 100, and the first electrode region A1 and the second electrode region A2 are respectively on both sides of the channel region A0 of the third active layer ACT3 in the first direction D1. At least a part of the third active layer ACT3 between a channel region A013 of the sensing transistor T31 of the first sub-pixel SP1 and a channel region A013 of the sensing transistor T33 of the third sub-pixel SP3 is used as both a first electrode region A113 of the sensing transistor T31 of the first sub-pixel SP1 and a second electrode region A213 of the sensing transistor of the third sub-pixel SP3; and/or, at least a part of the third active layer ACT3 between a channel region A024 of the sensing transistor T32 of the second sub-pixel SP2 and a channel region A024 of the sensing transistor T34 of the fourth sub-pixel SP4 is used as both a first electrode region A124 of the sensing transistor T32 of the second sub-pixel SP2 and a second electrode region A224 of the sensing transistor T34 of the fourth sub-pixel SP4.

In some exemplary embodiments of the present disclosure, referring to FIG. 3, the third gate G31 of the sensing transistor T31 of the first sub-pixel SP1 and the third gate G33 of the sensing transistor T33 of the third sub-pixel SP3 are symmetrical relative to a first centerline, and the first centerline is an imaginary straight line that passes through a center of the sensing line SL and extends in the second direction D2; and/or the third gate G32 of the sensing transistor T32 of the second sub-pixel SP2 and the third gate G34 of the sensing transistor T34 of the fourth sub-pixel SP4 are symmetrical relative to the first centerline M1.

By designing the sensing transistors T3 of the plurality of sub-pixels to be bilateral symmetrical relative to the sensing line SL, the cross-line length in the signal scanning line in the first direction D1 may be reduced, greatly saving the wiring space, reducing the process defect rates, and improving the display quality of the display panel.

In some exemplary embodiments of the present disclosure, referring to FIGS. 3 and 4C, the third active layer ACT313 of the sensing transistor T31 of the first sub-pixel SP1 and the third active layer ACT313 of the sensing transistor T33 of the third sub-pixel SP3 are connected to each other and extend in the first direction D1. That is to say, the sensing transistor T31 of the first sub-pixel SP1 and the sensing transistor T33 of the third sub-pixel SP3 may share the source and the drain. Two connection holes may be reduced by designing the two sensing transistors of two adjacent sub-pixels in the same row in a source-drain-shared mode, thereby further saving the wiring space, increasing the aperture ratio of the display substrate, and improving the display quality of the display panel.

In some exemplary embodiments of the present disclosure, referring to FIG. 4E, the first protruding portion 111 and the second protruding portion 112 protrude in the second direction D2 from the main body portion 110 of the same scanning signal line towards opposite directions, and the first protruding portion 111 and the second protruding portion 112 are offset in the first direction D1 by a first predetermined distance D12; and/or, the third protruding portion 113 and the fourth protruding portion 114 protrude in the second direction D2 from the main body portion 110 of the same scanning signal line towards opposite directions, and the third protruding portion 113 and the fourth protruding portion 114 are offset in the first direction D1 by a second predetermined distance D34.

In some exemplary embodiments of the present disclosure, referring to FIGS. 3, 4C, and 4E, the pixel driving circuit also includes a switching transistor T2, and the switching transistor T2 includes a second gate G2 and a second active layer ACT2. For example, the driving circuit of the first sub-pixel SP1 includes a switching transistor T21, which includes a second gate G21 and a second active layer ACT21. The plurality of protruding portions include a fifth protruding portion 115 and a sixth protruding portion 116, an orthographic projection of the fifth protruding portion 115 on the base substrate 100 at least partially overlaps with a second active layer ACT21 of a switching transistor T21 of the first sub-pixel SP1, a part of the fifth protruding portion 115 overlapping with the second active layer ACT21 of the switching transistor T21 of the first sub-pixel SP1 is a second gate G21 of the switching transistor T21 of the first sub-pixel SP1. An orthographic projection of the sixth protruding portion 116 on the base substrate 100 at least partially overlaps with a second active layer ACT22 of a switching transistor T22 of the second sub-pixel SP2, and a part of the sixth protruding portion 116 overlapping with the second active layer ACT22 of the switching transistor T22 of the second sub-pixel SP2 is a second gate G22 of the switching transistor T22 of the second sub-pixel SP2. The second gate G21 of the switching transistor T21 of the first sub-pixel SP1 and the second gate G22 of the switching transistor T22 of the second sub-pixel SP2 are respectively on both sides of the main body portion 110 of the same scanning signal line GL in the second direction D2.

The wiring space may be greatly saved by designing the switching transistors T2 of the plurality of sub-pixels on upper and lower sides of the signal scanning line, thereby reducing the process defect rates and improving the display quality of the display panel.

In some exemplary embodiments of the present disclosure, referring to FIG. 4E, the fifth protruding portion 115 and the sixth protruding portion 116 protrude in the second direction D2 from the main body portion 110 of the same scanning signal line GL towards opposite directions, and the fifth protruding portion 115 and the sixth protruding portion 116 are offset in the first direction D1 by a third predetermined distance D56.

In some exemplary embodiments of the present disclosure, referring to FIG. 4E, any two of the first predetermined distance D12, the second predetermined distance D34, and the third predetermined distance D56 are substantially equal.

For example, referring to FIG. 4J, the display substrate also includes a first data line DL1, a second data line DL2, a third data line DL3, and a fourth data line DL4. The first data line DL1, the second data line DL2, the third data line DL3, and the fourth data line DL4 are located in the second conductive layer 20.

Referring to FIGS. 3 and 4J, the first data line DL1 is electrically connected to the switching transistor T21 of the first sub-pixel SP1 for writing the data signal to the first sub-pixel SP1. The second data line DL2 is electrically connected to the switching transistor T22 of the second sub-pixel SP2 for writing the data signal to the second sub-pixel SP2. Similarly, the third data line DL3 is electrically connected to the switching transistor of the third sub-pixel SP3 for writing the data signal to the third sub-pixel SP3. The fourth data line DL4 is electrically connected to the switching transistor of the third sub-pixel SP4 for writing the data signal to the fourth sub-pixel SP4.

Due to limitations in the spatial arrangement of data lines, the first data line DL1 and the second data line DL2 are offset by a fourth predetermined distance D012 in the first direction D1, and the third data line DL3 and the fourth data line DL4 are offset by a fifth predetermined distance D034 in the first direction D1. It should be noted that the offset distance between data lines here may refer to the minimum or average spacing distance between two adjacent data lines.

In embodiments of the present disclosure, the first electrode (source or drain) of the switching transistor T21 of the first sub-pixel SP1 is electrically connected to the first data line DL1 through the third conductive connection portion 123 and the third via hole VH3. Similarly, the first electrode (source or drain) of the switching transistor T22 of the second sub-pixel SP2 is electrically connected to the second data line DL2, the first electrode (source or drain) of the switching transistor T23 of the third sub-pixel SP3 is electrically connected to the third data line DL3, and the first electrode (source or drain) of the switching transistor T24 of the fourth sub-pixel SP4 is electrically connected to the fourth data line DL4. For the first sub-pixel SP1 and the third sub-pixel SP3 located in the same row, the first electrode of the switching transistor of the first sub-pixel SP1 is electrically connected to the first data line DL1 located on the outer side, and the first electrode of the switching transistor of the third sub-pixel SP3 is electrically connected to the third data line DL3 located on the inner side. For the second sub-pixel SP2 and the fourth sub-pixel SP4 located in the same row, the first electrode of the switching transistor of the second sub-pixel SP2 is electrically connected to the second data line DL2 located on the inner side, and the first electrode of the switching transistor of the fourth sub-pixel SP4 is electrically connected to the fourth data line DL4 located on the outer side.

In order to ensure that a distance the data signal passes through from the data writing transistor to the driving transistor does not deviate too much, for example, to ensure that the distance the data signal passes through from the switching transistor T21 of the first sub-pixel SP1 to the driving transistor T11 of the first sub-pixel SP1 is deviated relatively small, offset design is performed on the plurality of protruding portions. For example, the first protruding portion 111 and the second protruding portion 112 are offset by the first predetermined distance D12 in the first direction D1. The third protruding portion 113 and the fourth protruding portion 114 are offset by the second predetermined distance D34 in the first direction D1. The fifth protruding portion 115 and the sixth protruding portion 116 are offset by the third predetermined distance D56 in the first direction D1.

For example, in some embodiments, any two of the first offset distance D12, the third predetermined distance D56, and the fourth predetermined distance D012 may be substantially equal. For example, in other embodiments, the third predetermined distance D56 is greater than the first offset distance D12; and/or; the third predetermined distance D56 is greater than the fourth predetermined distance D012; and/or; the fourth predetermined distance D012 is greater than the first offset distance D12.

By providing the third gate G3 of the sensing transistor T3 and the second gate G2 of the switching transistor T2 of the plurality of sub-pixels on both sides of the main body portion 110 of the same scanning signal line, as well as regularly offsetting the third gate G3 of the sensing transistor T3 and the second gate G2 of the switching transistor T2 of the plurality of sub-pixels by a certain distance in the first direction D1, the space on both sides of the main body portion 110 of the scanning signal line may be fully utilized, which may reduce the cross-line length of the horizontal scanning signal line, further save the wiring space, and improve the aperture ratio, thereby achieving the high PPI design for display panels. In some exemplary embodiments of the present disclosure, referring to FIGS. 3 and 4B, a sensing signal line SL includes a line main body portion 210, a first line protruding portion 211 and a second line protruding portion 212, the first line protruding portion 211 protrudes from the line main body portion 210 towards the first sub-pixel SP1, and the second line protruding portion 212 protrudes from the line main body portion 210 towards the fourth sub-pixel SP4.

Referring to FIG. 4E, the display substrate further includes a first conductive connection portion 121 and a sixth conductive connection portion 126. The first conductive connection portion 121, the sixth conductive connection portion 126, the first protruding portion 111, the second protruding portion 112, the third protruding portion 113, and the fourth protruding portion 114 are located in the same layer. The first conductive connection portion 121 is located between the first protruding portion 111 and the third protruding portion 113 in the first direction D1. The sixth conductive connection portion 126 is located between the second protruding portion 112 and the fourth protruding portion 114 in the first direction D1.

Referring to FIGS. 3, 4B, and 4E, an orthographic projection of the first line protruding portion 211 on the base substrate 100 at least partially overlaps with an orthographic projection of the first conductive connection portion 121 on the base substrate 100, and the first line protruding portion 211 is electrically connected to the first conductive connection portion 121 through a first via hole VH1. An orthographic projection of the second line protruding portion 212 on the base substrate 100 at least partially overlaps with an orthographic projection of the sixth conductive connection portion 126 on the base substrate 100, and the second line protruding portion 212 is electrically connected to the sixth conductive connection portion 126 through a seventh via hole VH7.

Referring to FIG. 4B, the display substrate further includes a first conductive conversion portion 221 and a second conductive conversion portion 222. The first conductive conversion portion 221, the second conductive conversion portion 222, the first line protruding portion 211, and the second line protruding portion 212 are located in the same layer. Referring to FIGS. 3, 4B, and 4E, an orthographic projection of the first conductive conversion portion 221 on the base substrate 100 at least partially overlaps with an orthographic projection of the second conductive connection portion 122 on the base substrate 100. The first conductive conversion portion 221 is electrically connected to the second conductive connection portion 122 through the second via hole VH2. An orthographic projection of the second conductive conversion portion 222 on the base substrate 100 at least partially overlaps with an orthographic projection of the fourth conductive connection portion 124 on the base substrate 100. The second conductive conversion portion 222 is electrically connected to the fourth conductive connection portion 124 through the eighth via hole VH8. In some exemplary embodiments of the present disclosure, referring to FIGS. 3, 4C, and 4E, an orthographic projection of one of the first conductive connection portion 121 and the first via hole VH1 on the base substrate 100 at least partially overlaps with an orthographic projection of a part of the third active layer ACT3 used as both a first electrode region A113 of the sensing transistor T31 of the first sub-pixel SP1 and a second electrode region A213 of the sensing transistor T33 of the third sub-pixel SP3 on the base substrate 100.

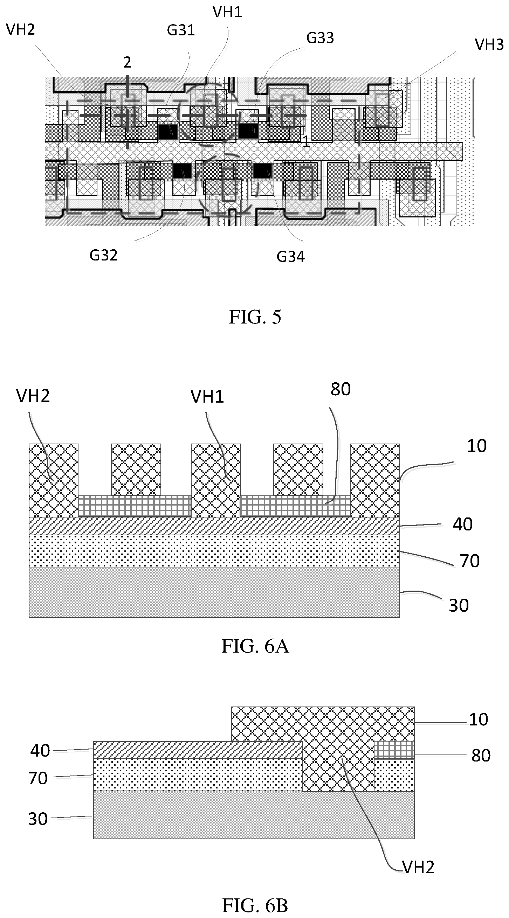

FIG. 5 is a local enlarged view of a region close to a dashed rectangular region in FIG. 3. FIG. 6A is a cross-sectional view taken along a dashed line 1 in FIG. 5, and FIG. 6B is a cross-sectional view taken along a dashed line 2 in FIG. 5, where an orthographic projection of the dashed line 1 and an orthographic projection of the dashed line 2 on a base substrate partially overlap with a first via hole VH2. Referring to FIGS. 3, 4C, and 6A, the third active layer ACT313 of the first sub-pixel SP1 in the display substrate is electrically connected to the first conductive layer 10 through the first via hole VH1 and the second via hole VH2, respectively, to form the source and the drain of the sensing transistor T31 of the first sub-pixel SP1.

In some exemplary embodiments of the present disclosure, referring to FIG. 4E, the display substrate further includes a second conductive connection portion 122, the second conductive connection portion 122, the first protruding portion 111, and a fifth protruding portion 115 are in the same layer, and the second conductive connection portion 122 is between the first protruding portion 111 and the fifth protruding portion 115 in the first direction D1.

Referring to FIGS. 3, 4A, 4C, and 4E, the display substrate further includes a light shielding portion 31 on the base substrate 100, orthographic projections of any two of the light shielding portion 31, a second electrode region A213 of the sensing transistor T31 of the first sub-pixel SP1, and the second conductive connection portion 122 on the base substrate 100 at least partially overlap, and the second electrode region A213 of the sensing transistor T31 of the first sub-pixel SP1 is electrically connected to the light shielding portion 31 through the second conductive connection portion 122 and a second via hole VH2.

Referring to FIGS. 3, 4A, 4G, and 4H, the display substrate also includes a first electrode 91 of the light-emitting element and a first electrode via hole VHR of the light-emitting element located on the base substrate 100. For example, the first electrode 91 of the light-emitting element includes a first electrode 913 of the light-emitting element of the third sub-pixel SP3, the first electrode via hole VHR of the light-emitting element includes a first electrode via hole VHR3 of the light-emitting element of the third sub-pixel SP3, and the light shielding portion 31 includes a light shielding portion 313 of the third sub-pixel SP3. The first electrode 913 of the light-emitting element of the third sub-pixel SP3 is electrically connected to the light shielding portion 313 of the third sub-pixel SP3 through the first electrode via hole VHR3 of the light-emitting element of the third sub-pixel SP3.

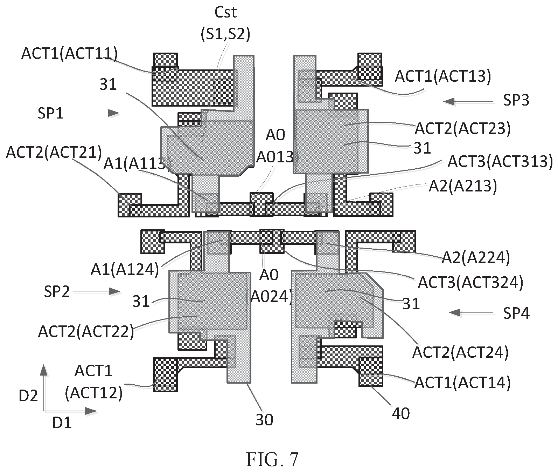

FIG. 7 is a planar schematic diagram of a stack of a local light shielding layer 30 and an active layer 40 according to some exemplary embodiments of the present disclosure.

In some exemplary embodiments of the present disclosure, referring to FIG. 7, an orthographic projection of a second active layer ACT2 on the base substrate 100 at least partially overlaps with an orthographic projection of the light shielding portion 31 on the base substrate. The pixel driving circuit further includes a storage capacitor Cst, the storage capacitor Cst includes a first electrode plate S1 and a second electrode plate S2, at least a part of the second active layer ACT2 is used as the first electrode plate S1, and at least a part of the light shielding portion 31 is used as the second electrode plate S2. Through the design of the driving circuit, for example, the sensing transistors T3 are evenly distributed on the upper and lower sides of the main body portion 110 of the scanning signal line and are bilateral symmetrical, which may save the wiring space and save a higher space for the storage capacitor, thereby facilitating the increase of the capacitance value of the storage capacitor.

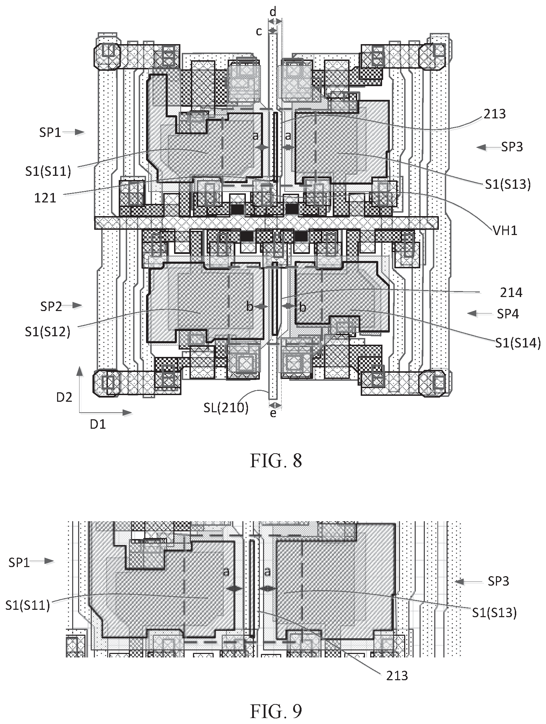

FIG. 8 is a local plan view of a display substrate according to other embodiments of the present disclosure, which shows a widening portion of a sensing signal line. FIG. 9 is a local enlarged view of a region close to a dashed box above in FIG. 8.

In some other exemplary embodiments of the present disclosure, referring to FIGS. 8 and 9, the sensing signal line SL also includes a first widening portion 213, a width d of the first widening portion 213 in the first direction D1 is greater than a width c of the line main body portion 210 in the first direction D1, and an orthographic projection of the first widening portion 213 on the base substrate 100 is between an orthographic projection of a first electrode plate S11 of a storage capacitor of the first sub-pixel SP1 on the base substrate and an orthographic projection of a first electrode plate S13 of a storage capacitor of the third sub-pixel SP3 on the base substrate in the first direction D1; and/or, referring to FIG. 8, the sensing signal line SL further includes a second widening portion 214, a width e of the second widening portion 214 in the first direction D1 is greater than the width c of the line main body portion 210 in the first direction D1, and an orthographic projection of the second widening portion 214 on the base substrate is between an orthographic projection of a first electrode plate S12 of a storage capacitor of the second sub-pixel SP2 on the base substrate and an orthographic projection of a first electrode plate S14 of a storage capacitor of the fourth sub-pixel 4 on the base substrate in the first direction.

Referring to FIGS. 7, 8, and 9, the orthographic projection of the first widening portion 213 on the base substrate and the orthographic projection of the first electrode plate S11 of the storage capacitor of the first sub-pixel SP1 on the base substrate are spaced by a first spacing distance a in the first direction D1. The first electrode plate S11 of the storage capacitor of the first sub-pixel SP1 is a region of the second active layer ACT21 of the first sub-pixel SP1 overlapping with the light shielding portion 31. The orthographic projection of the first widening portion 213 on the base substrate and the orthographic projection of the first electrode plate S13 of the storage capacitor of the third sub-pixel SP3 on the base substrate are spaced by a second spacing distance a in the first directionD1. The first electrode plate S13 of the storage capacitor of the third sub-pixel SP3 is a region of the second active layer ACT23 of the third sub-pixel SP3 overlapping with the light shielding portion 31. The first spacing distance is substantially equal to the second spacing distance. And/or, the orthographic projection of the second widening portion 214 on the base substrate and the orthographic projection of the first electrode plate S12 of the storage capacitor of the second sub-pixel SP2 on the base substrate are spaced by a third spacing distance b in the first direction D1. The first electrode plate S12 of the storage capacitor of the second sub-pixel SP2 is a region of the second active layer ACT22 of the second sub-pixel SP2 overlapping with the light shielding portion 31. The orthographic projection of the second widening portion 214 on the base substrate and the orthographic projection of the first electrode plate S14 of the storage capacitor of the fourth sub-pixel SP4 on the base substrate are spaced by a fourth spacing distance b in the first direction D1. The first electrode plate S14 of the storage capacitor of the fourth sub-pixel SP4 is a region of the second active layer ACT24 of the fourth sub-pixel SP4 overlapping with the light shielding portion 31. The third spacing distance is substantially equal to the fourth spacing distance.

For example, referring to FIGS. 3 and 4C, the driving transistor T11 of the first sub-pixel SP1 is electrically connected to the storage capacitor of the first sub-pixel SP1 through the fourth via hole VH4. The storage capacitor of the first sub-pixel SP1 may be used to store the driving voltage, ensuring the stability of pixel driving.

In an exemplary embodiment, the spacing distance a may be substantially equal to the spacing distance b, that is, any two of the first spacing distance, the second spacing distance, the third spacing distance, and the fourth spacing distance are substantially equal.

It should be noted that in the present disclosure, unless otherwise specified, the expression "substantially equal" may include various situations where the ratio of two compared values is in a range of 0.8 to 1.2. For example, the two compared values are equal, or the ratio of the two compared values is 0.8, 0.9, 1.1, 1.2, etc.

By horizontally providing the sensing transistors of the plurality of sub-pixels and evenly distributing the sensing transistors of the plurality of sub-pixels on upper and lower sides of the scanning signal line, the source and the drain are shared by the sensing transistors T3 of the two sub-pixels, that is, the sensing transistors T3 of the plurality of sub-pixels are symmetrical about the sensing signal line SL, while a widened design is adopted to the sensing signal line SL in the opening region of the left and right sub-pixels, which may ensure that the distances between the sensing signal line SL and the first gates G1 of the driving transistors T1 of the sub-pixels are equal, thus having the same impact on the potentials of the first gates G1 of the driving transistors T1 of the sub-pixels. In another aspect, the widened design for the sensing signal line SL in the opening region of the left and right sub-pixels also helps to reduce the resistance of the sensing signal line SL, reduce the voltage drop, and improve the brightness uniformity of each sub-pixel, thereby improving the display effect of the display panel.

In some other exemplary embodiments of the present disclosure, referring to FIGS. 4E and 8, the display substrate also includes a first conductive connection portion 121, and the first conductive connection portion 121, the first protruding portion 111, and the second protruding portion 112 are in the same layer. The orthographic projection of the first widening portion 213 on the base substrate at least partially overlaps with an orthographic projection of the first conductive connection portion 121 on the base substrate, and the first widening portion 213 is electrically connected to the first conductive connection portion through the first via hole VH1.

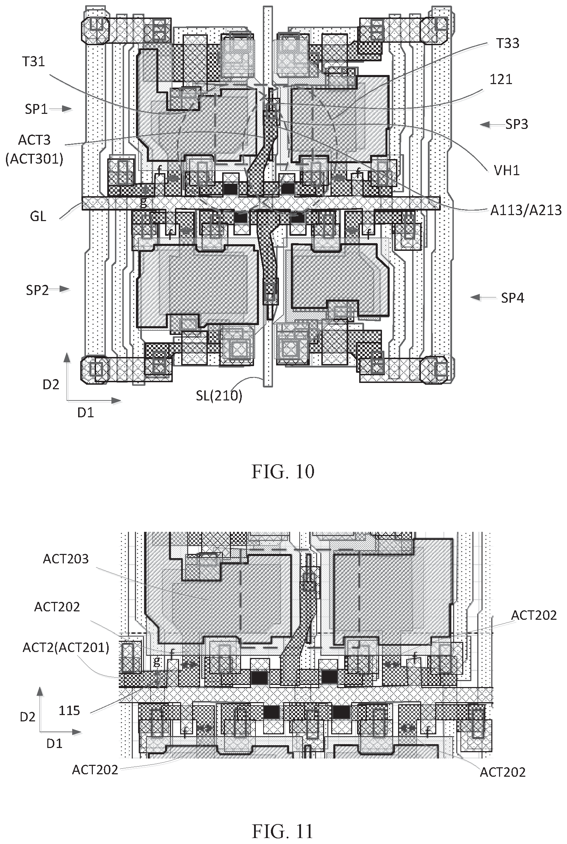

FIG. 10 is a local plan view of a display substrate according to other embodiments of the present disclosure, which shows an active extension portion of a third active layer. FIG. 11 is a local enlarged view of a region close to a scanning signal line in the middle of FIG. 10.

In some other exemplary embodiments of the present disclosure, referring to FIGS. 10 and 11, the third active layer ACT3 further includes an active extension portion ACT301, and the active extension portion ACT301 extends from the part of the third active layer ACT3 used as both the first electrode region A113 of the sensing transistor T31 of the first sub-pixel SP1 and the second electrode region A213 of the sensing transistor T33 of the third sub-pixel SP3 in a direction parallel to an extension direction of the sensing signal line SL. An orthographic projection of the active extension portion ACT301 on the base substrate at least partially overlaps with an orthographic projection of the sensing signal line SL on the base substrate. The active extension portion ACT301 is electrically connected to the first conductive connection portion 121.

Referring to FIGS. 10 and 11, the second active layer ACT2 includes a first part ACT201 extending in the first direction D1, a second part ACT202 extending in the second direction D2, and a third part ACT203 used as the first electrode plate S1, a part of the first part ACT201 overlapping with the fifth protruding portion 115 is a channel region of a switching transistor, and the second part ACT202 is connected with the first part ACT201 and the third part ACT203; and a width f of the second part ACT202 in the first direction D1 is greater than a width g of the first part ACT201 in the second direction.

By horizontally providing the sensing transistors of the plurality of sub-pixels and evenly distributing the sensing transistors of the plurality of sub-pixels on upper and lower sides of the scanning signal line, the source and the drain are shared by the sensing transistors T3 of the two sub-pixels, that is, the sensing transistors T3 of the plurality of sub-pixels are symmetrical about the sensing signal line SL, while a widened design is adopted to the sensing signal line SL in the opening region of the left and right sub-pixels, which may ensure that the distances between the sensing signal line SL and the third gates G3 of the sensing transistors T3 of the sub-pixels are equal, thus having the same impact on the potentials of the third gates G3 of the sensing transistors T3 of the sub-pixels. In another aspect, the source-drain-shared end is connected with the sensing signal line SL through the first via hole VH1. The first via hole VH1 is provided on the sensing signal line SL, which may save the wiring space in the first direction D1 and is conducive to increasing the width of the high impedance second active layer ACT2, such as the width of the second part ACT202 of the second active layer ACT2, which is conducive to the potential input of the scanning signal line and further improving the aperture ratio, while the double-layer design may also reduce the resistance of the sensing signal line SL, reduce the voltage drop, and improve the brightness uniformity of each sub-pixel, thereby improving the display effect of the display panel.

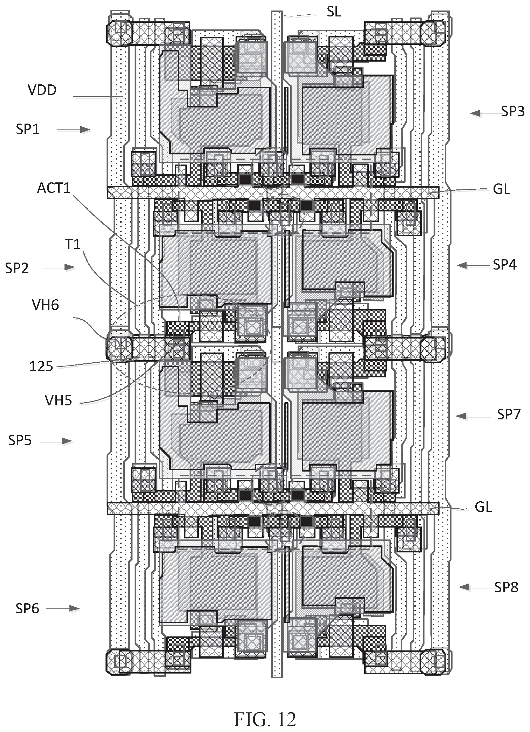

FIG. 12 is a local plan view of a display substrate according to other embodiments of the present disclosure.

In some other exemplary embodiments of the present disclosure, referring to FIGS. 4E and 12, the pixel driving circuit also includes a driving transistor T1, and the driving transistor T1 includes a first active layer ACT1. The display substrate also includes a fifth conductive connection portion 125 and a first power signal line VDD used to transmit a first power signal, the fifth conductive connection portion 125 and the scanning signal line GL are in the same layer, and the first power signal line VDD and the sensing signal line SL are in the same layer. An end of the fifth conductive connection portion 125 is electrically connected to the first active layer ACT1 through a fifth via hole VH5, and the other end of the fifth conductive connection portion is electrically connected to the first power signal line VDD through a sixth via hole VH6; and the fifth conductive connection portion is shared by two sub-pixels in adjacent rows of pixel units and in the same column. For example, the second sub-pixel SP2 and the fifth sub-pixel SP5 are two sub-pixels located in adjacent two rows of pixel units and in the same column, respectively. The second sub-pixel SP2 and the fifth sub-pixel SP5 may share the fifth conductive connection portion 125. In this way, the wiring space may be saved and the aperture ratio may be further improved, thereby enhancing the display effect of the display panel.

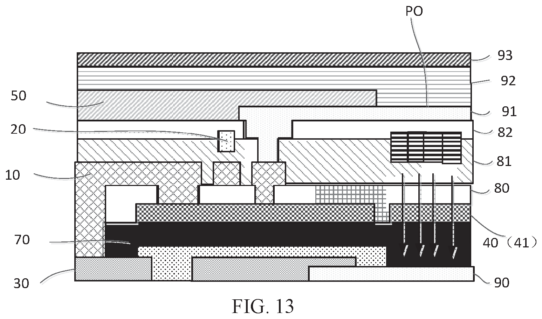

FIG. 13 is a local cross-section view of a display substrate according to other embodiments of the present disclosure.

For example, referring to FIG. 13, the display substrate includes: a semiconductor layer 40 on the base substrate; a first conductive layer 10 on a side of the semiconductor layer 40 away from the base substrate; a second conductive layer 20 on a side of the first conductive layer 10 away from the base substrate; and a light shielding layer 30 on a side of the semiconductor layer 40 facing the base substrate. Referring to FIGS. 4A, 4B, 4C, and 4E, the light shielding portion 31 is in the light shielding layer 30, the first active layer ACT1, the second active layer ACT2, and the third active layer ACT3 are in the semiconductor layer 40, the scanning signal line GL, the first conductive connection portion 121, and the second conductive connection portion 122 are in the first conductive layer 10, and the sensing signal line SL and the first power line VDD are in the second conductive layer 20.

For example, referring to FIG. 13, the display substrate also includes a pixel defining layer 50 on a side of the second conductive layer 20 away from the base substrate. The pixel defining layer 50 is used to define a plurality of pixel openings. The display substrate also includes a reflective electrode layer 93 on a side of the pixel defining layer 50 away from the base substrate.

Referring to FIGS. 3, 4I, and 13, the pixel defining layer 50 is also used to define a plurality of slots 52, the plurality of slots 52 are between any two adjacent pixel openings, and at least a part of the reflective electrode layer 93 is in the plurality of slots 52, so as to avoid crosstalk between adjacent pixels and improve the stability of the display panel.

For example, in some embodiments of the present disclosure, referring to FIGS. 7 and 13, the display substrate further includes a first conductive portion 90 on a side of the light shielding layer 30 facing the base substrate; and a second conductive portion 41 in the semiconductor layer 40. An orthographic projection of the first conductive portion 90 on the base substrate at least partially overlaps with an orthographic projection of the pixel opening PO on the base substrate, and an orthographic projection of the second conductive portion 41 on the base substrate at least partially overlaps with the orthographic projection of the pixel opening PO on the base substrate. The first electrode plate S1 also includes the second conductive portion 41, the second electrode plate S2 also includes the first conductive portion 90, the first conductive portion 90 is electrically connected to the light shielding portion 30, and the first conductive portion 90 includes a transparent conductive material, such as ITO and IZO.

Optionally, embodiments of the present disclosure further provide a display device, which may include the aforementioned display substrate. The display device may include but is not limited to products or components with display functions, such as an electronic paper, a mobile phone, a tablet computer, a display, a laptop, a digital photo frame, and a navigation device. It should be understood that the display device has the same beneficial effect as the display substrate provided in the aforementioned embodiments.

Although some embodiments of the overall concept of the present disclosure have been shown and explained, those ordinary skilled in the art may understand that changes may be made to these embodiments without departing from the principles and spirit of the overall concept of the present disclosure. The scope of the present disclosure is defined by the claims and their equivalents.

## Claims

1. A display substrate, comprising:
a base substrate;
a plurality of pixel units on the base substrate, wherein at least one of the plurality of pixel units comprises a plurality of sub-pixels, at least one of the plurality of sub-pixels comprises a light-emitting element and a pixel driving circuit configured to drive the light-emitting element, the plurality of sub-pixels of the plurality of pixel units are arranged in an array in a first direction and a second direction on the base substrate, and the first direction intersects with the second direction; and
a scanning signal line on the base substrate, wherein the scanning signal line comprises a main body portion extending in the first direction and a plurality of protruding portions extending in the second direction,
wherein the pixel driving circuit comprises a sensing transistor, and the sensing transistor comprises a third gate and a third active layer;
wherein the plurality of sub-pixels of at least one pixel unit comprise a first sub-pixel and a second sub-pixel, the first sub-pixel is in an i^{th} row and a j^{th} column, the second sub-pixel is in an (i+1)^{th} row and the j^{th} column, and i and j are positive integers greater than or equal to 1;
wherein the plurality of protruding portions comprise a first protruding portion and a second protruding portion, an orthographic projection of the first protruding portion on the base substrate at least partially overlaps with a third active layer of a sensing transistor of the first sub-pixel, a part of the first protruding portion overlapping with the third active layer of the sensing transistor of the first sub-pixel is a third gate of the sensing transistor of the first sub-pixel; an orthographic projection of the second protruding portion on the base substrate at least partially overlaps with a third active layer of a sensing transistor of the second sub-pixel, and a part of the second protruding portion overlapping with the third active layer of the sensing transistor of the second sub-pixel is a third gate of the sensing transistor of the second sub-pixel; and
wherein the third gate of the sensing transistor of the first sub-pixel and the third gate of the sensing transistor of the second sub-pixel are respectively on both sides of a main body portion of a same scanning signal line in the second direction.

2. The display substrate according to claim 1, wherein the plurality of sub-pixels of at least one pixel unit further comprise a third sub-pixel and a fourth sub-pixel, the third sub-pixel is in the i^{th} row and a (j+1)^{th} column, and the fourth sub-pixel is in the (i+1)^{th} row and the (j+1)^{th} column;
wherein the plurality of protruding portions further comprise a third protruding portion and a fourth protruding portion, an orthographic projection of the third protruding portion on the base substrate at least partially overlaps with a third active layer of a sensing transistor of the third sub-pixel, a part of the third protruding portion overlapping with the third active layer of the sensing transistor of the third sub-pixel is a third gate of the sensing transistor of the third sub-pixel; an orthographic projection of the fourth protruding portion on the base substrate at least partially overlaps with a third active layer of a sensing transistor of the fourth sub-pixel, and a part of the fourth protruding portion overlapping with the third active layer of the sensing transistor of the fourth sub-pixel is a third gate of the sensing transistor of the fourth sub-pixel; and
wherein the third gate of the sensing transistor of the third sub-pixel and the third gate of the sensing transistor of the fourth sub-pixel are respectively on both sides of the main body portion of the same scanning signal line in the second direction.

3. The display substrate according to claim 2, wherein the display substrate further comprises a sensing signal line extending in the second direction, and the sensing signal line is configured to provide a sensing signal to the pixel driving circuit; and
wherein the third gate of the sensing transistor of the first sub-pixel and the third gate of the sensing transistor of the third sub-pixel are respectively on both sides of a same sensing signal line in the first direction; and/or, the third gate of the sensing transistor of the second sub-pixel and the third gate of the sensing transistor of the fourth sub-pixel are respectively on both sides of a same sensing signal line in the first direction.

4. The display substrate according to claim 2 or 3, wherein the third active layer of the sensing transistor further comprises a channel region, a first electrode region, and a second electrode region;
wherein an orthographic projection of the channel region of the third active layer on the base substrate at least partially overlaps with an orthographic projection of the third gate on the base substrate, and the first electrode region and the second electrode region are respectively on both sides of the channel region of the third active layer in the first direction; and
wherein at least a part of the third active layer between a channel region of the sensing transistor of the first sub-pixel and a channel region of the sensing transistor of the third sub-pixel is used as both a first electrode region of the sensing transistor of the first sub-pixel and a second electrode region of the sensing transistor of the third sub-pixel; and/or, at least a part of the third active layer between a channel region of the sensing transistor of the second sub-pixel and a channel region of the sensing transistor of the fourth sub-pixel is used as both a first electrode region of the sensing transistor of the second sub-pixel and a second electrode region of the sensing transistor of the fourth sub-pixel.

5. The display substrate according to any one of claims 2 to 4, wherein the third gate of the sensing transistor of the first sub-pixel and the third gate of the sensing transistor of the third sub-pixel are symmetrical relative to a first centerline, and the first centerline is an imaginary straight line that passes through a center of a sensing line and extends in the second direction; and/or
wherein the third gate of the sensing transistor of the second sub-pixel and the third gate of the sensing transistor of the fourth sub-pixel are symmetrical relative to the first centerline.

6. The display substrate according to any one of claims 2 to 5, wherein the third active layer of the sensing transistor of the first sub-pixel and the third active layer of the sensing transistor of the third sub-pixel are connected to each other and extend in the first direction.

7. The display substrate according to any one of claims 2 to 6, wherein the first protruding portion and the second protruding portion protrude in the second direction from the main body portion of the same scanning signal line towards opposite directions, and the first protruding portion and the second protruding portion are offset in the first direction by a first predetermined distance; and/or,
wherein the third protruding portion and the fourth protruding portion protrude in the second direction from the main body portion of the same scanning signal line towards opposite directions, and the third protruding portion and the fourth protruding portion are offset in the first direction by a second predetermined distance.

8. The display substrate according to any one of claims 2 to 7, wherein the pixel driving circuit further comprises a switching transistor, and the switching transistor comprises a second gate and a second active layer;
wherein the plurality of protruding portions comprise a fifth protruding portion and a sixth protruding portion, an orthographic projection of the fifth protruding portion on the base substrate at least partially overlaps with a second active layer of a switching transistor of the first sub-pixel, a part of the fifth protruding portion overlapping with the second active layer of the switching transistor of the first sub-pixel is a second gate of the switching transistor of the first sub-pixel; an orthographic projection of the sixth protruding portion on the base substrate at least partially overlaps with a second active layer of a switching transistor of the second sub-pixel, and a part of the sixth protruding portion overlapping with the second active layer of the switching transistor of the second sub-pixel is a second gate of the switching transistor of the second sub-pixel; and
wherein the second gate of the switching transistor of the first sub-pixel and the second gate of the switching transistor of the second sub-pixel are respectively on both sides of the main body portion of the same scanning signal line in the second direction.

9. The display substrate according to claim 8, wherein the fifth protruding portion and the sixth protruding portion protrude in the second direction from the main body portion of the same scanning signal line towards opposite directions, and the fifth protruding portion and the sixth protruding portion are offset in the first direction by a third predetermined distance.

10. The display substrate according to claim 9, wherein any two of the first predetermined distance, the second predetermined distance, and the third predetermined distance are substantially equal.

11. The display substrate according to any one of claims 2 to 10, wherein the sensing signal line comprises a line main body portion and a first line protruding portion, and the first line protruding portion protrudes from the line main body portion towards the first sub-pixel;
wherein the display substrate further comprises a first conductive connection portion, the first conductive connection portion, the first protruding portion, and the third protruding portion are in a same layer, and the first conductive connection portion is between the first protruding portion and the third protruding portion in the first direction; and
wherein an orthographic projection of the first line protruding portion on the base substrate at least partially overlaps with an orthographic projection of the first conductive connection portion on the base substrate, and the first line protruding portion is electrically connected to the first conductive connection portion through a first via hole.

12. The display substrate according to claim 11, wherein an orthographic projection of one of the first conductive connection portion and the first via hole on the base substrate at least partially overlaps with an orthographic projection of a part of the third active layer used as both a first electrode region of the sensing transistor of the first sub-pixel and a second electrode region of the sensing transistor of the third sub-pixel on the base substrate.

13. The display substrate according to claim 12, wherein the display substrate further comprises a second conductive connection portion, the second conductive connection portion, the first protruding portion, and the fifth protruding portion are in a same layer, and the second conductive connection portion is between the first protruding portion and the fifth protruding portion in the first direction; and
wherein the display substrate further comprises a light shielding portion on the base substrate, orthographic projections of any two of the light shielding portion, a second electrode region of the sensing transistor of the first sub-pixel, and the second conductive connection portion on the base substrate at least partially overlap, and the second electrode region of the sensing transistor of the first sub-pixel is electrically connected to the light shielding portion through the second conductive connection portion and a second via hole.

14. The display substrate according to claim 13, wherein an orthographic projection of a second active layer on the base substrate at least partially overlaps with an orthographic projection of the light shielding portion on the base substrate; and
wherein the pixel driving circuit further comprises a storage capacitor, the storage capacitor comprises a first electrode plate and a second electrode plate, at least a part of the second active layer is used as the first electrode plate, and at least a part of the light shielding portion is used as the second electrode plate.

15. The display substrate according to claim 14, wherein the sensing signal line further comprises a first widening portion, a width of the first widening portion in the first direction is greater than a width of the line main body portion in the first direction, and an orthographic projection of the first widening portion on the base substrate is between an orthographic projection of a first electrode plate of a storage capacitor of the first sub-pixel on the base substrate and an orthographic projection of a first electrode plate of a storage capacitor of the third sub-pixel on the base substrate in the first direction; and/or,
wherein the sensing signal line further comprises a second widening portion, a width of the second widening portion in the first direction is greater than the width of the line main body portion in the first direction, and an orthographic projection of the second widening portion on the base substrate is between an orthographic projection of a first electrode plate of a storage capacitor of the second sub-pixel on the base substrate and an orthographic projection of a first electrode plate of a storage capacitor of the fourth sub-pixel on the base substrate in the first direction.

16. The display substrate according to claim 15, wherein the orthographic projection of the first widening portion on the base substrate and the orthographic projection of the first electrode plate of the storage capacitor of the first sub-pixel on the base substrate are spaced by a first spacing distance in the first direction; the orthographic projection of the first widening portion on the base substrate and the orthographic projection of the first electrode plate of the storage capacitor of the third sub-pixel on the base substrate are spaced by a second spacing distance in the first direction; and the first spacing distance is substantially equal to the second spacing distance; and/or,
wherein the orthographic projection of the second widening portion on the base substrate and the orthographic projection of the first electrode plate of the storage capacitor of the second sub-pixel on the base substrate are spaced by a third spacing distance in the first direction; the orthographic projection of the second widening portion on the base substrate and the orthographic projection of the first electrode plate of the storage capacitor of the fourth sub-pixel on the base substrate are spaced by a fourth spacing distance in the first direction; and the third spacing distance is substantially equal to the fourth spacing distance.

17. The display substrate according to claim 15 or 16, wherein the display substrate further comprises a first conductive connection portion, and the first conductive connection portion, the first protruding portion, and the second protruding portion are in a same layer; and
wherein the orthographic projection of the first widening portion on the base substrate at least partially overlaps with an orthographic projection of the first conductive connection portion on the base substrate, and the first widening portion is electrically connected to the first conductive connection portion through the first via hole.

18. The display substrate according to claim 17, wherein the third active layer further comprises an active extension portion, and the active extension portion extends from the part of the third active layer used as both the first electrode region of the sensing transistor of the first sub-pixel and the second electrode region of the sensing transistor of the third sub-pixel in a direction parallel to an extension direction of the sensing signal line;
wherein an orthographic projection of the active extension portion on the base substrate at least partially overlaps with an orthographic projection of the sensing signal line on the base substrate; and
wherein the active extension portion is electrically connected to the first conductive connection portion.

19. The display substrate according to claim 18, wherein the second active layer comprises a first part extending in the first direction, a second part extending in the second direction, and a third part used as the first electrode plate, a part of the first part overlapping with the fifth protruding portion is a channel region of the switching transistor, and the second part is connected with the first part and the third part; and
wherein a width of the second part in the first direction is greater than a width of the first part in the second direction.

20. The display substrate according to any one of claims 1 to 19, wherein the pixel driving circuit further comprises a driving transistor, and the driving transistor comprises a first active layer;
wherein the display substrate further comprises a fifth conductive connection portion and a first power signal line configured to transmit a first power signal, the fifth conductive connection portion and the scanning signal line are in a same layer, and the first power signal line and the sensing signal line are in a same layer;
wherein an end of the fifth conductive connection portion is electrically connected to the first active layer through a fifth via hole, and the other end of the fifth conductive connection portion is electrically connected to the first power signal line through a sixth via hole; and
wherein the fifth conductive connection portion is shared by two sub-pixels in adjacent rows of pixel units and in a same column.

21. The display substrate according to any one of claims 13 to 19, wherein the display substrate comprises:
a semiconductor layer on the base substrate;
a first conductive layer on a side of the semiconductor layer away from the base substrate;
a second conductive layer on a side of the first conductive layer away from the base substrate; and
a light shielding layer on a side of the semiconductor layer facing the base substrate,
wherein the light shielding portion is in the light shielding layer, the first active layer, the second active layer, and the third active layer are in the semiconductor layer, the scanning signal line, the first conductive connection portion, and the second conductive connection portion are in the first conductive layer, and the sensing signal line and the first power line are in the second conductive layer.

22. The display substrate according to claim 21, wherein the display substrate further comprises: a pixel defining layer on a side of the second conductive layer away from the base substrate, wherein the pixel defining layer is configured to define a plurality of pixel openings; and a reflective electrode layer on a side of the pixel defining layer away from the base substrate; and
wherein the pixel defining layer is further configured to define a plurality of slots, the plurality of slots are between any two adjacent pixel openings, and at least a part of the reflective electrode layer is in the plurality of slots.

23. The display substrate according to claim 22, wherein the display substrate further comprises a first conductive portion on a side of the light shielding layer facing the base substrate; and a second conductive portion in the semiconductor layer;
wherein an orthographic projection of the first conductive portion on the base substrate at least partially overlaps with an orthographic projection of the pixel opening on the base substrate, and an orthographic projection of the second conductive portion on the base substrate at least partially overlaps with the orthographic projection of the pixel opening on the base substrate; and
wherein the first electrode plate further comprises the second conductive portion, the second electrode plate further comprises the first conductive portion, the first conductive portion is electrically connected to the light shielding portion, and the first conductive portion comprises a transparent conductive material.

24. The display substrate according to any one of claims 8 to 10, wherein the display substrate further comprises a plurality of data lines in the second conductive layer, the plurality of data lines comprise a first data line, a second data line, a third data line, and a fourth data line, the first data line is electrically connected to a first electrode of the switching transistor of the first sub-pixel, the second data line is electrically connected to a first electrode of the switching transistor of the second sub-pixel, the third data line is electrically connected to a first electrode of a switching transistor of the third sub-pixel, and the fourth data line is electrically connected to a first electrode of a switching transistor of the fourth sub-pixel; and
wherein the first and second data lines are on a side of the pixel driving circuit of the pixel unit in the first direction, the third and fourth data lines are on the other side of the pixel driving circuit of the pixel unit in the first direction, the first and second data lines are spaced in the first direction, the first data line is on a side of the second data line away from the pixel driving circuit of the pixel unit, and the fourth data line is on a side of the third data line away from the pixel driving circuit of the pixel unit.

25. A display device comprising the display substrate according to any one of claims 1 to 24.
